Europäisches Patentamt

European Patent Office

Office européen des brevets

(19)

(11) **EP 1 505 174 A1**

(12) **EUROPEAN PATENT APPLICATION**

(43) Date of publication:
**09.02.2005 Bulletin 2005/06**

(51) Int Cl.7: **C23C 16/515**, C23C 16/24

(21) Application number: **04016125.9**

(22) Date of filing: **08.07.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(30) Priority: **30.07.2003 JP 2003203707**

(71) Applicant: **Sharp Kabushiki Kaisha
Osaka-shi Osaka (JP)**

(72) Inventors:
• **Fujioka, Yasushi
Soraku-gun Kyoto (JP)**

• **Shimizu, Akira
Nara (JP)**
• **Fukuda, Hiroyuki
Shiki-gun Nara (JP)**
• **Nomoto, Katsuhiko
Kashiwara-shi Osaka (JP)**

(74) Representative: **Müller - Hoffmann & Partner
Patentanwälte,
Innere Wiener Strasse 17
81667 München (DE)**

(54) **Manufacturing method of silicon thin film solar cell**

(57)     To uniformly form a silicon thin film for a solar cell, having an i layer (94) formed with crystalline silicon, on a substrate of a large area to provide a high power solar cell, in a manufacturing method of a silicon thin film solar cell, a silicon thin film, having a structure such that an i layer (94) is sandwiched between a p layer (93) and an n layer (95), is formed on a substrate with a high frequency plasma CVD method, wherein i layer (94) is formed with crystalline silicon using plasma with pulse-modulated high frequency power, one cycle of pulse modulation includes an ON state for outputting high frequency power and an OFF state for not outputting, an output waveform is modulated to be rectangular, a time of the ON state is 1 - 100 microseconds, and a time of the OFF state is 5 microseconds or longer.

FIG.2

## Description

This nonprovisional application is based on Japanese Patent Application No. 2003-203707 filed with the Japan Patent Office on July 30, 2003 the entire contents of which are hereby incorporated by reference.

BACKGROUND OF THE INVENTION

Field of the Invention

The present invention relates to a method of forming a crystalline silicon thin film in a silicon thin film solar cell.

Description of the Background Art

A kind of general silicon thin film solar cell has a structure such that, on a translucent insulation substrate of glass or the like, a transparent conductive film of $SnO_2$, ITO or the like is formed, and then a p layer, an i layer and an n layer, or an n layer, an i layer and a p layer of amorphous semiconductor are respectively stacked thereon in this order to form a photoelectric conversion active layer, on which a backside electrode of a metal thin film is stacked. Another kind has a structure such that, an n layer, an i layer and a p layer, or a p layer, an i layer and an n layer of amorphous semiconductor are respectively stacked in this order on a metal substrate electrode to form a photoelectric conversion active layer, on which a transparent conductive film is stacked. The former one, wherein layers are stacked on the translucent insulation substrate, is mainly used in these days because the translucent insulation substrate can be made as a cover glass on a surface of the solar cell, and a newly developed plasma-resistant transparent conductive film of $SnO_2$ or the like enables stacking of the photoelectric conversion active layer of amorphous semiconductor thereon with a plasma CVD method.

Despite energetic research and development until now, an amorphous solar cell having the aforementioned structure of translucent insulation substrate (glass) /transparent conductive film /p layer-amorphous i layer-n layer semiconductor /backside electrode has only low conversion efficiency such as a level of 10-12 % for a device of 10 cm per side. Therefore, attempts to increase the conversion efficiency have been made by applying a crystalline material in place of an amorphous material which was mainly used for a solar cell until now, such as by forming a p layer or an n layer of an amorphous solar cell with crystalline silicon as described in, for example, Japanese Patent Laying-Open No. 57-187971.

A thin film of amorphous semiconductor is formed by vapor deposition using a plasma CVD method with glow discharge decomposition of material gas or a photo CVD method, which method has an advantage that a thin film of a large area can be formed. In addition, as described in Japanese Patent Laying-Open No. 5-156451, a pulse discharge is recently used to suppress generation of a powder (a powdery substance of polymerized silicon) in a plasma CVD process to form an amorphous material.

A main frequency of plasma with the glow discharge decomposition used for thin film formation is an RF (radio frequency) of 13.56 MHz, and secondly, microwave plasma of 2.45 GHz is under study. Few studies have been made as to effects of frequencies other than the RF and microwave in a high frequency band, because only the RF and microwave are allocated as high frequencies for industries. In these days, however, an amorphous film and a crystalline thin film using a very high frequency located between the RF and microwave are examined. As an example, it is known that a crystalline thin film in an i layer of a solar cell device was formed at 70 MHz (J. Meier "INTRINSIC MICROC-RYSTALLINE SILICON ($\mu$c-Si:H) - A PROMISING NEW THIN FILM SOLAR CELL MATERIAL" First WCPEC, Hawaii 1994 Dec 5-9 pp. 409-412). Formation of a crystalline silicon thin film with a pulse discharge is also known, as described in Japanese Patent Laying-Open No. 10-313125, but conditions of pulse modulation are hardly disclosed in the art.

SUMMARY OF THE INVENTION

When a microcrystalline or polycrystalline thin film is used as an i layer of a silicon thin film solar cell, an amount of light absorption at long wavelengths increases and an output current increases as compared with an amorphous thin film. High frequency power to an amount of material gas flow must be increased to form a crystalline thin film with a plasma CVD method as compared with an amorphous thin film. When the high frequency power to the amount of material gas flow is increased, however, material gas is decomposed before uniformly diffused within a thin film formation space. Therefore, though a uniform formation of a crystalline thin film on a substrate of a large area is desired, supply and decomposition states of material gas tend to be uneven, and thus a thickness and crystallinity of the crystalline thin film formed on the substrate may become uneven. Such problem may be solved by pulse modulation of the high frequency power, but the effect largely differs depending on a condition of the pulse modulation and performance of the thin film solar cell may be decreased in some conditions.

An object of the present invention is to uniformly form a silicon thin film for a solar cell, having an i layer formed with crystalline silicon, on a substrate of a large area by selecting a suitable condition for pulse modulation to provide a high power solar cell.

For attaining the object, a manufacturing method of a silicon thin film solar cell according to the present invention is a manufacturing method of a solar cell wherein a silicon thin film, having a structure such that an i layer is sandwiched between a p layer and an n layer, is formed on a substrate with a high frequency plasma CVD method. The present invention is characterized in that, the i layer is formed with crystalline silicon, that the i layer is formed using plasma with pulse-modulated high frequency power, and that one cycle of pulse modulation includes an ON state for outputting the high frequency power and an OFF state for not outputting, an output waveform is modulated to be rectangular, a time of the ON state in the cycle of pulse modulation is 1 - 100 microseconds, and a time of the OFF state is 5 microseconds or longer.

It is preferable that, an average output per cycle of the pulse-modulated high frequency power is equal to an output of high frequency power in a situation wherein a microcrystalline silicon layer is formed under the same material gas condition without pulse modulation. In the present invention, microcrystalline silicon can be formed as the crystalline silicon, and the present invention is effective when a substrate having an area of 0.3 $m^2$ or larger is used. It is preferable that, material gas used in the high frequency plasma CVD is continuously supplied when the i layer is formed with pulse modulation. Furthermore, the high frequency power preferably has a frequency of 27 MHz or higher.

The silicon thin film solar cell is preferably a solar cell having a single device structure having p, i and n layers all formed with crystalline silicon. In addition, the silicon thin film solar cell preferably has a tandem device structure formed by stacking a solar cell device, at least an i layer thereof is formed with crystalline silicon, and a solar cell device, at least an i layer thereof is formed with amorphous silicon. In addition, the silicon thin film solar cell preferably has a tandem device structure formed by stacking a solar cell device having p, i and n layers all formed with crystalline silicon and a solar cell device having p, i and n layers all formed with amorphous silicon.

According to the present invention, a thin film including an i type crystalline silicon layer can be formed uniformly on a substrate of a large area, and thus a high power solar cell can be manufactured.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 schematically shows a manufacturing apparatus for carrying out a manufacturing method according to the present invention.
Fig. 2 shows an output waveform of pulse-modulated high frequency power according to the present invention.
Figs. 3-5 show output waveforms of pulse-modulated high frequency power which are not corresponding to the present invention.
Figs. 6-8 show output waveforms of pulse-modulated high frequency power according to the present invention.
Fig. 9 schematically shows a silicon thin film solar cell having a single device structure, which is formed with the manufacturing method according to the present invention.
Fig. 10 schematically shows a silicon thin film solar cell having a tandem device structure, which is formed with the manufacturing method according to the present invention.

DESCRIPTION OF THE PREFERRED EMBODIMENTS

A manufacturing method of a silicon thin film solar cell according to the present invention is a manufacturing method of a solar cell wherein at least a p (or an n) type silicon layer, an i type silicon layer and an n (or a p) type silicon layer are stacked on a substrate using a high frequency plasma CVD method. The i layer is formed using plasma with pulse-modulated high frequency power. One cycle of pulse modulation includes an ON state for outputting the high frequency power and an OFF state for not outputting. An output waveform is modulated to be rectangular. A time of the ON state in the cycle of pulse modulation is set to 1 - 100 microseconds, and a time of the OFF state is set to 5 microseconds or longer.

When a crystalline thin film is used as an i layer of a silicon thin film solar cell, an amount of light absorption at long wavelengths increases as compared with an amorphous thin film, and a high power solar cell can be manufactured. Large high frequency power must be applied, however, to form an i layer of crystalline silicon with a high frequency plasma CVD method, and when the large high frequency power is continuously applied, as material gas is decomposed before uniformly diffused over a substrate, a thickness and crystallinity of the crystalline thin film formed on the substrate may become uneven.

By pulse modulation of high frequency power in the present invention, material gas is diffused when the high frequency power is not applied, which enables the thickness and crystallinity of the crystalline thin film to be uniform. Furthermore, by the pulse modulation to make the output waveform of the high frequency power rectangular, the cycle of pulse modulation including an ON state for outputting the high frequency power and an OFF state for not outputting, and setting of the time of the ON state in the cycle of pulse modulation to 1 - 100 microseconds and the time of the OFF state to 5 microseconds or longer, a crystalline silicon thin film of high quality can be formed uniformly. That is, by the pulse modulation of the output waveform of the high frequency power to make a rectangular waveform wherein large high frequency power is switched ON/OFF, as a film of low crystallinity or an amorphous film is not formed in the OFF state wherein the high frequency power is substantially not applied, and as plasma is formed with substantially constant large high frequency power in the ON state, a uniform crystalline silicon film can be formed.

The film can be formed with stable high-density plasma with little effect of rise and fall transient states of an output of the high frequency power by setting a time of the ON state in the cycle of pulse modulation to 1 microsecond or longer, preferably to 2 microseconds or longer, and more preferably to 5 microseconds or longer. In addition, generation of a powder by vapor deposition of gas is suppressed even in the high-density plasma and a high-quality crystalline silicon film without defect can be provided by setting a time of the ON state to 100 microseconds or less, preferably to 50 microseconds or less, and more preferably to 30 microseconds or less. On the other hand, by setting a time of the OFF state in the cycle of pulse modulation to 5 microseconds or longer, preferably to 10 microseconds or longer, and more preferably to 20 microseconds or longer, the OFF time wherein the high frequency power is not applied is made longer than a life of excited radical, and thus the material gas is diffused without decomposition by the excited radical, resulting in uniform thickness and crystallinity of the crystalline thin film formed on the substrate. In addition, the OFF time of the high frequency power is preferably 500 microseconds or less, and more preferably 100 microseconds or less, to suppress a decrease in plasma energy by the pulse modulation and attain crystallinity and a film formation speed similar to those under a continuous discharge condition.

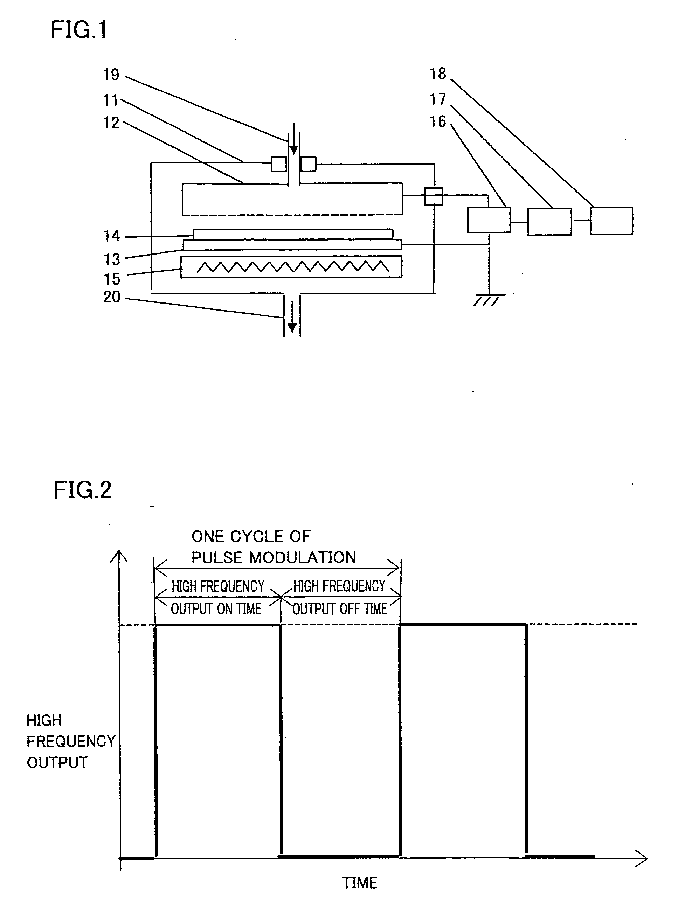

The manufacturing method of a silicon thin film solar cell according to the present invention is described in detail based on Fig. 1. Fig. 1 schematically shows an example of a typical manufacturing apparatus for carrying out the manufacturing method according to the present invention, for forming a silicon thin film on a substrate with a high frequency plasma CVD method. As shown in Fig. 1, there are opposed electrodes 12 and 13 within a reaction chamber 11, a substrate 14 is arranged on electrode 13, and substrate 14 is heated with a heater 15. A high frequency power supply 17 is connected to electrodes 12 and 13 via a matching circuit 16 to apply high frequency power. A pulse oscillator circuit 18 is connected to high frequency power supply 17 to perform pulse modulation of the high frequency power. In addition, material gas supplied from a gas inlet tube 19 connected to a gas supply system (not shown) is introduced into reaction chamber 11 in a shower-like manner from fine gas inlet holes of electrode 12, and is exhausted from an exhaust tube 20 connected to an exhaust system (not shown).

Fig. 2 shows an example of a pulse-modulated output waveform according to the present invention. As shown in Fig. 2, a horizontal axis represents time and a vertical axis represents output of high frequency power. In the manufacturing method of a silicon thin film solar cell according to the present invention, an i layer formed with crystalline silicon is formed using plasma with pulse-modulated high frequency power, one cycle of pulse modulation includes an ON state for applying substantially constant output of the high frequency power for a prescribed time and an OFF state for substantially not applying the high frequency power for a prescribed time and, as shown in Fig. 2, the output waveform is modulated to be rectangular. The time of the ON state in the cycle of pulse modulation is set to 1 - 100 microseconds, and the time of the OFF state is set to 5 microseconds or longer.

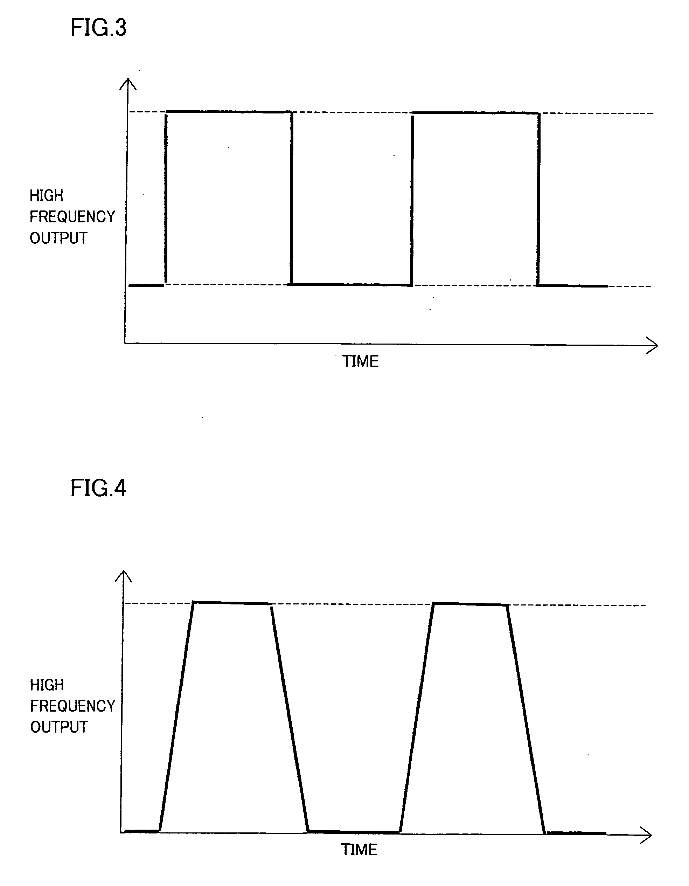

Figs. 3-5 show examples of pulse-modulated output waveforms which are not corresponding to the present invention. In pulse modulation shown in Fig. 3, high frequency power is alternately output at two levels, that is, high and low levels. As the low output level is not the OFF state wherein the high frequency power is substantially not applied, this situation does not correspond to the present invention. Even when the high frequency power is not set to the complete OFF state, however, it can be considered as the OFF state wherein the high frequency power is substantially not applied if the level is sufficiently low so that the film is substantially not formed, and thus the situation is also included in the present invention. When there is an extremely low output in the OFF state such as 1 % of an output for the ON state or lower, for example, the situation can be considered as the pulse modulation of the rectangular waveform according to the present invention because the film is substantially not formed.

In pulse modulation shown in Fig. 4, though high frequency power has ON and OFF output states, this situation does not correspond to the present invention because the high frequency power gradually varies between the ON and OFF states. If the gradually varying state of the high frequency power between the ON and OFF states lasts for only a short time so that the film is substantially not formed, however, the situation can be considered as the pulse modulation of the rectangular waveform, and is also included in the present invention. When an oscillation frequency of the high frequency power is 27.12 MHz, for example, it is difficult to make modulation in a time shorter than 0.037 microseconds, which is a time for one cycle thereof. As the film is substantially not formed if the gradually varying state of the high frequency power between the ON and OFF states only lasts for such a short time, the situation can be considered as the pulse modulation of the rectangular waveform according to the present invention.

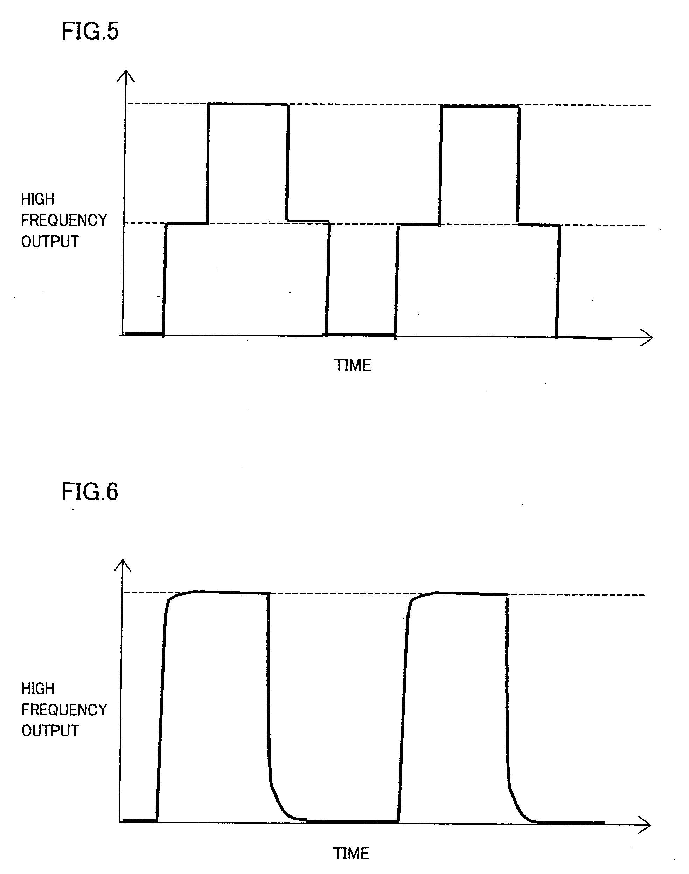

In pulse modulation shown in Fig. 5, though high frequency power has ON and OFF output states, this situation does not correspond to the present invention because there are two levels of high frequency output in the ON state, which differs from the ON state wherein substantially constant output of the high frequency power is applied for a prescribed time. Even when the output of the high frequency power in the ON state is not strictly constant, however, if the film formed with the pulse modulation plasma is maintained in a range to have desired crystallinity, the situation can be considered as the output modulation of the rectangular waveform, and is also included in the present invention. When there is such a small variation as 1 % or lower in the output in the ON state, for example, as it causes little change in the crystallinity of the formed film, the situation can be considered as the pulse modulation of the rectangular waveform according to the present invention.

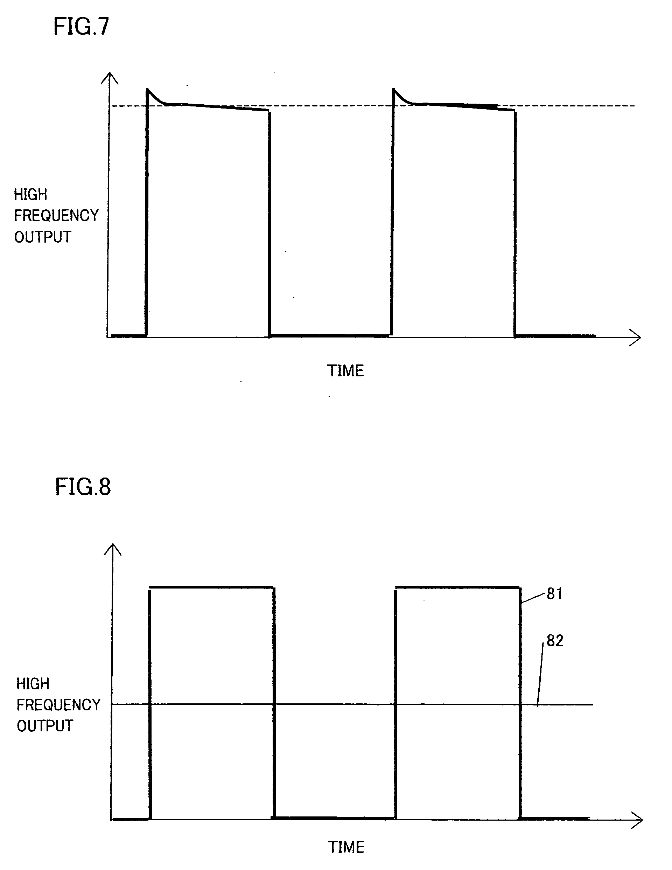

Figs. 6 and 7 show other examples of pulse-modulated output waveforms according to the present invention. When high frequency power is pulse-modulated, an amplitude of the high frequency may not become a simple variation, but may become a variation having a time constant in many situations depending on the high frequency power supply or the electrode. Fig. 6 shows an example of a pulse-modulated waveform which has time constants on rising and falling edges. As a rise time and a fall time, however, are sufficiently short compared with one cycle of the pulse modulation in the example shown in Fig. 6, the effect thereof can be considered substantially little. Therefore, this situation is also included in the present invention. Fig. 7 shows an example of a pulse-modulated waveform which has an overshoot on a rising edge. As a time of the overshoot, however, is sufficiently short compared with one cycle of the pulse modulation in the example shown in Fig. 7, the effect thereof can be considered substantially little. Therefore, this situation is also included in the present invention.

It is preferable that, an average output per cycle of the pulse-modulated high frequency power is equal to an output of high frequency power in a situation wherein a microcrystalline silicon layer is formed under the same material gas condition without pulse modulation. When an intermittent discharge is performed with an output equal to a high frequency output required to obtain microcrystallinity to form an i layer of crystalline silicon without pulse modulation, as a time of the ON state in one cycle of pulse modulation is as short as 1-100 microseconds in the present invention, energy of generated plasma decreases, and the formed film has decreased crystallinity and is easily set to an amorphous state, and a film formation speed also decreases. To avoid such situation, it is desirable to set an average output per cycle after the pulse modulation equal to an output required to obtain a microcrystalline layer under the same material gas condition without the pulse modulation.

Fig. 8 shows an example of a pulse-modulated output waveform according to the present invention. In the example shown in Fig. 8, a modulation duty (hereinafter also referred to as "a time ratio") of a waveform 81 (a fundamental wave is not shown) of a pulse-modulated high frequency output is 1/2. The modulation duty is expressed by the following equation.

$$\text{Modulation duty} = \text{ON state time}/(\text{ON state time} + \text{OFF state time})$$

An output waveform 82 (a fundamental wave is not shown) indicates high frequency power in a situation wherein microcrystalline silicon is formed under the same material gas condition without the pulse modulation. A microcrystalline film can be formed when an output of pulse-modulated waveform 81 in the ON state is set to twice an output of waveform 82 without the pulse modulation, and an average output per cycle after the pulse modulation is set equal to an output without the pulse modulation. Similarly, when a time ratio of the ON state in one cycle is 1/3, for example, energy of plasma would not decrease with the pulse modulation and crystallinity and a film formation speed similar to those in a continuous discharge can be attained by tripling the high frequency power and equalizing the average value.

Herein, a microcrystalline state means a mixed state of a crystalline state and an amorphous state wherein both of a crystal peak of 520 $\text{cm}^{-1}$ and an amorphous peak of 480 $\text{cm}^{-1}$ are observed when crystallinity of a formed film is measured with Raman spectroscopy.

The manufacturing method according to the present invention is markedly effective when a thin film of microcrystalline silicon is formed. Crystalline silicon can be classified according to crystallinity, such as to microcrystalline silicon, polycrystalline (poly-) silicon or monocrystalline silicon, and microcrystalline silicon has a property of changeable crystallinity depending on conditions of a plasma CVD method. According to the present invention, however, a thin film of microcrystalline silicon can be formed uniformly on a substrate of a large area by performing pulse modulation in a suitable condition.

It is preferable that, material gas used in the high frequency plasma CVD is continuously supplied when the i layer is formed with pulse modulation. In the present invention, uniform crystal and uniform film thickness are accomplished by controlling plasma by means of pulse modulation of high frequency power, which can be controlled at high speed. Therefore, with regard to supply of material gas which is difficult to control, controllability of plasma can be enhanced by continuously supplying the gas without changing an amount of gas flow with time.

The manufacturing method according to the present invention is markedly effective when a thin film is formed on a substrate having an area of 0.3 $m^2$ or larger. That is, according to the present invention, a crystalline silicon layer having uniform crystallinity and uniform thickness can be formed on a substrate of a large area with pulse modulation of high frequency power. The effect of pulse modulation according to the present invention, however, is small when a film is formed on a substrate having a small area such as less than 0.3 $m^2$, because material gas is diffused sufficiently on the substrate without pulse modulation. According to the present invention, a silicon layer having uniform crystallinity and uniform thickness can be easily formed even on a substrate having an area of 0.3 $m^2$ or larger, which has difficulty in diffusing material gas.

The high frequency power used in the present invention preferably has a frequency of 27 MHz or higher. In the present invention, plasma of high density and high energy must be generated within a short application time of high frequency power to form a crystalline silicon film by the plasma CVD with the pulse-modulated high frequency power. Though an industrial frequency RF 13.56 MHz is most generally used for the plasma CVD, energy of a high frequency discharge becomes higher as the frequency increases. Therefore, by using a higher frequency, that is, a VHF frequency which is equal to or higher than 27 MHz in the present invention, high-energy plasma can be obtained more easily with the pulse modulation and a silicon film having higher crystallinity can be formed.

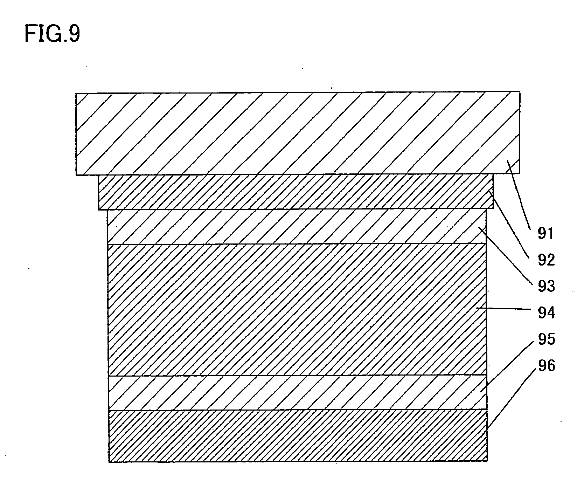

Fig. 9 shows a typical example of a silicon thin film solar cell formed with the manufacturing method according to the present invention. As shown in Fig. 9, a transparent conductive layer 92 is formed on a translucent insulation substrate 91, and then a p (or an n) type silicon layer 93, an i type crystalline silicon layer 94, an n (or a p) type silicon layer 95, and a backside electrode layer 96 are stacked. Silicon layers are similar in the p-i-n order or in the n-i-p order. A glass substrate or the like is used as translucent insulation substrate 91, while an $SnO_2$ film or a ZnO film is used as transparent conductive layer 92. As i type crystalline silicon layer 94, microcrystalline silicon or polycrystalline (poly-) silicon is formed.

Though amorphous silicon, microcrystalline silicon or polycrystalline (poly-) silicon may be formed as the n and p layers, it is preferable that the p and n layers are crystalline silicon layers as the i layer. The present invention relates to a manufacturing method of a silicon thin film solar cell formed by stacking of at least a p (or an n) type silicon layer, an i type crystalline silicon layer and an n (or a p) type silicon layer on a substrate, and when the solar cell has a single device structure having the p, i and n layers all formed with crystalline silicon, a conductivity is increased and a high-efficiency silicon thin film solar cell can be accomplished. As backside electrode layer 96, a metal film of silver, aluminum or the like, or a stacked film of a ZnO film and a metal film is used. As the substrate, an opaque material such as aluminum, stainless or carbon is used. A transparent conductive layer can be formed on a surface opposite to the substrate side.

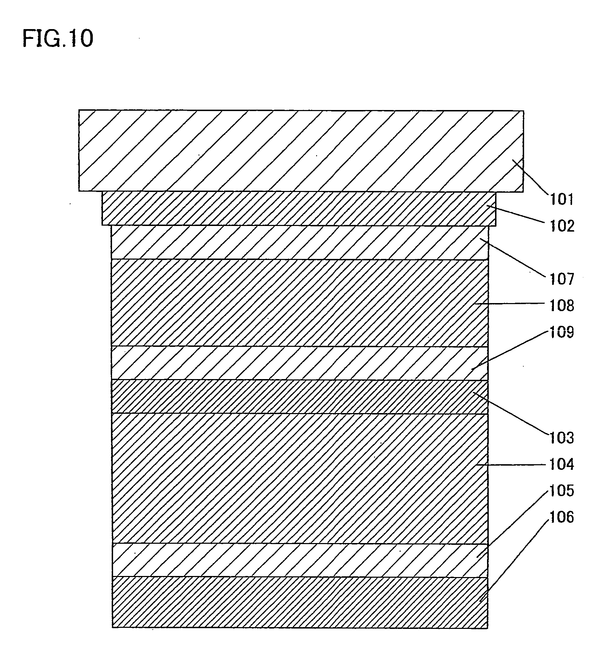

Fig. 10 shows another typical example of a silicon thin film solar cell formed with the manufacturing method according to the present invention. As shown in Fig. 10, a transparent conductive layer 102 is formed on a translucent insulation substrate 101, and then a p (or an n) type silicon layer 107, an i type amorphous silicon layer 108 and an n (or a p) type silicon layer 109 are stacked, and thereafter, a p (or an n) type silicon layer 103, an i type crystalline silicon layer 104, an n (or a p) type silicon layer 105, and a backside electrode layer 106 are stacked to form a silicon thin film solar cell of a tandem structure. Silicon layers are similar in the p-i-n-p-i-n order or in the n-i-p-n-i-p order.

Though microcrystalline silicon or polycrystalline (poly-) silicon may be formed as i type crystalline silicon layer 104, and amorphous silicon, amorphous silicon carbide, microcrystalline silicon, or polycrystalline (poly-) silicon may be formed as the n and p type silicon layers, the solar cell preferably has a tandem device structure formed by stacking a solar cell device having the p, i and n layers all formed with crystalline silicon and a solar cell device having the p, i and n layers all formed with amorphous silicon. The present invention relates to a manufacturing method of a silicon thin film solar cell having an i type crystalline silicon layer and including a solar cell device formed with p-i-n junction or n-i-p junction, and when the solar cell has the tandem device structure formed by stacking a solar cell device having the p, i and n layers all formed with crystalline silicon and a solar cell device having the p, i and n layers all formed with amorphous silicon, as crystalline silicon and amorphous silicon have different wavelength ranges of light absorbance, light of wide wavelength range can be absorbed, and thus a high-efficiency silicon thin film solar cell can be accomplished.

As backside electrode layer 106, a metal film of silver, aluminum or the like, or a stacked film of a ZnO film and a metal film is used. As the substrate, an opaque material such as aluminum, stainless or carbon is used. A transparent conductive layer can be formed on a surface opposite to the substrate side.

First Example

Three chambers as reaction chamber 11 of the manufacturing apparatus shown in Fig. 1 were prepared and connected in a line via gate valves. A silicon thin film solar cell was manufactured with the manufacturing method according to the present invention using an apparatus wherein p, i and n layers of the silicon thin film can be formed on a substrate respectively in the three reaction chambers with the high frequency plasma CVD method.

A glass substrate of a large area having a size of 1000 mm $\times$ 500 mm and having a transparent conductive layer formed on a surface thereof was used as the substrate. The substrate was heated to about 200 °C in a first reaction chamber, and then mixed gas of $SiH_4$, $H_2$ and $B_2H_6$ was introduced as material gas, and high frequency power of continuous wave was applied to the electrode to form a p type microcrystalline silicon layer on the substrate. Then the substrate was moved to a second reaction chamber, whereinto mixed gas of $SiH_4$ and $H_2$ was introduced as material gas, and pulse-modulated high frequency power was applied to the electrode to form an i type microcrystalline silicon layer on the substrate with generated plasma.

Pulse modulation was output modulation having a rectangular waveform including an ON state for outputting the high frequency power and an OFF state for not outputting the high frequency power, wherein a time of the ON state in one cycle of the pulse modulation was 20 microseconds and a time of the OFF state was 20 microseconds. An oscillation frequency of the high frequency power was 27.12 MHz, and an output of the high frequency power in the ON state was set to twice an output with which a microcrystalline silicon film can be obtained under the same gas condition without the pulse modulation.

Thereafter, the substrate was moved to a third reaction chamber, whereinto mixed gas of $SiH_4$, $H_2$ and $PH_3$ was introduced as material gas, and high frequency power of continuous wave was applied to the electrode to form an n type microcrystalline silicon layer on the substrate. The substrate was then cooled and removed from the manufacturing apparatus, and a ZnO transparent conductive layer and a silver electrode layer were formed and stacked using a known DC magnetron sputtering method to manufacture a silicon thin film solar cell of a single device structure, as shown in Fig. 9.

For a characteristic evaluation, after the solar cell was manufactured, the substrate was cut into 200 pieces each having a size of 50 mm $\times$ 50 mm, and a device having a size of 10 mm $\times$ 10 mm was patterned in a center of the substrate of 50 mm $\times$ 50 mm to examine a distribution of conversion efficiencies. As a result, average conversion efficiency of the 200 devices was as good as about 1.1 times that of devices manufactured without pulse modulation, and a variation in the conversion efficiencies was as good as $\pm 3$ % or smaller.

Comparative Example 1

In this comparative example, pulse modulation of high frequency power was not performed when the i type microcrystalline silicon layer was formed. In addition, except that high frequency power of continuous wave applied had an output of half of the high frequency output in the ON state after the pulse modulation in the first example, a silicon thin film solar cell was manufactured similarly as in the first example. Average conversion efficiency of the manufactured 200 devices was 0.91 times that of the devices in the first example manufactured with the pulse modulation, and a variation in the conversion efficiencies was as large as $\pm 12$ %.

Comparative Example 2

A silicon thin film solar cell was manufactured similarly as in the first example except that, when the i type microcrystalline silicon layer was formed, a time of OFF state in one cycle of the pulse modulation was set to 4 microseconds, and a high frequency output in the ON state was set to 1.2 times an output with which a microcrystalline silicon film can be obtained under the same gas condition without the pulse modulation. Average conversion efficiency of the manufactured 200 devices was 0.92 times that of the devices in the first example, and a variation in the conversion efficiencies was as large as $\pm 11$ %.

Comparative Example 3

A silicon thin film solar cell was manufactured similarly as in the first example except that, when the i type microcrystalline silicon layer was formed, a time of ON state in one cycle of the pulse modulation was set to 0.5 microseconds, and a high frequency output in the ON state was set to 41 times an output with which a microcrystalline silicon film can be obtained under the same gas condition without the pulse modulation. Average conversion efficiency of the manufactured 200 devices was 0.8 times that of the devices in the first example, and a variation in the conversion efficiencies was as large as $\pm 16$ %.

Comparative Example 4

A silicon thin film solar cell was manufactured similarly as in the first example, except that, when the i type microcrystalline silicon layer was formed, a time of ON state in one cycle of the pulse modulation was set to 150 microseconds, and a high frequency output in the ON state was set to 1.13 times an output with which a microcrystalline silicon film can be obtained under the same gas condition without the pulse modulation. Average conversion efficiency of the manufactured 200 devices was 0.90 times that of the devices in the first example, and a variation in the conversion efficiencies was as large as $\pm13$ %.

Second Example

Six chambers as reaction chamber 11 of the manufacturing apparatus shown in Fig. 1 were prepared and connected in a line via gate valves. A silicon thin film solar cell was manufactured with the manufacturing method according to the present invention using an apparatus wherein p, i, n, p, i, and n layers of the silicon thin film can be formed on a substrate respectively in the six reaction chambers with the high frequency plasma CVD method.

A glass substrate of a large area having a size of 1000 mm $\times$ 1000 mm and having a transparent conductive layer formed on a surface thereof was used as the substrate. The substrate was heated to about 200 °C in a first reaction chamber, and then mixed gas of $SiH_4$, $H_2$, $CH_4$, and $B_2H_6$ was introduced as material gas, and high frequency power of continuous wave was applied to the electrode to form a p type amorphous silicon carbide layer on the substrate. Then the substrate was moved to a second reaction chamber, whereinto mixed gas of $SiH_4$ and $H_2$ was introduced as material gas, and high frequency power of continuous wave was applied to the electrode to form an i type amorphous silicon layer on the substrate. Thereafter, the substrate was moved to a third reaction chamber, whereinto mixed gas of $SiH_4$, $H_2$ and $PH_3$ was introduced as material gas, and high frequency power of continuous wave was applied to the electrode to form an n type microcrystalline silicon layer on the substrate.

Then the substrate was moved to a fourth reaction chamber, and mixed gas of $SiH_4$, $H_2$ and $B_2H_6$ was introduced as material gas, and high frequency power of continuous wave was applied to the electrode to form a p type microcrystalline silicon layer on the substrate. Then the substrate was moved to a fifth reaction chamber, whereinto mixed gas of $SiH_4$ and $H_2$ was introduced as material gas, and pulse-modulated high frequency power was applied to the electrode to form an i type microcrystalline silicon layer on the substrate with generated plasma.

Pulse modulation was output modulation having a rectangular waveform including an ON state for outputting the high frequency power and an OFF state for not outputting the high frequency power, wherein a time of the ON state in one cycle of the pulse modulation was 10 microseconds and a time of the OFF state was 20 microseconds. An oscillation frequency of the high frequency power was 27.12 MHz, and an output of the high frequency power in the ON state was set to three times an output with which a microcrystalline silicon film can be obtained under the same gas condition without the pulse modulation.

Thereafter, the substrate was moved to a sixth reaction chamber, whereinto mixed gas of $SiH_4$, $H_2$ and $PH_3$ was introduced as material gas, and high frequency power of continuous wave was applied to the electrode to form an n type microcrystalline silicon layer on the substrate. The substrate was then cooled and removed from the manufacturing apparatus, and a ZnO transparent conductive layer and a silver electrode layer were formed and stacked using the known DC magnetron sputtering method to manufacture a silicon thin film solar cell of a tandem device structure, as shown in Fig. 10.

For a characteristic evaluation, after the solar cell was manufactured, the substrate was cut into 400 pieces each having a size of 50 mm $\times$ 50 mm, and a device having a size of 10 mm $\times$ 10 mm was patterned in a center of the substrate of 50 mm $\times$ 50 mm to examine a distribution of conversion efficiencies. As a result, average conversion efficiency of the 400 devices was as good as about 1.15 times that of devices manufactured without pulse modulation, and a variation in the conversion efficiencies was as good as $\pm3$ % or smaller.

Although the present invention has been described and illustrated in detail, it is clearly understood that the same is by way of illustration and example only and is not to be taken by way of limitation, the spirit and scope of the present invention being limited only by the terms of the appended claims.

**Claims**

1. A manufacturing method of a silicon thin film solar cell, a silicon thin film thereof, having a structure such that an i layer is sandwiched between a p layer and an n layer, is formed on a substrate with a high frequency plasma CVD method, wherein

said i layer is formed with crystalline silicon;

said i layer is formed using plasma with pulse-modulated high frequency power; and

one cycle of pulse modulation includes an ON state for outputting high frequency power and an OFF state for not outputting, an output waveform is modulated to be rectangular, a time of the ON state in the cycle of pulse modulation is 1 - 100 microseconds, and a time of the OFF state in the cycle is 5 microseconds or longer.

2. The manufacturing method of a silicon thin film solar cell according to claim 1, wherein
    an average output per cycle of the pulse-modulated high frequency power is equal to an output of high frequency power in a situation wherein a microcrystalline silicon layer is formed under a same material gas condition without pulse modulation.

3. The manufacturing method of a silicon thin film solar cell according to claim 1, wherein
    the crystalline silicon is microcrystalline silicon.

4. The manufacturing method of a silicon thin film solar cell according to claim 1, wherein
    material gas used in the high frequency plasma CVD is continuously supplied when said i layer is formed with pulse modulation.

5. The manufacturing method of a silicon thin film solar cell according to claim 1, wherein
    the substrate has an area of 0.3 $m^2$ or larger.

6. The manufacturing method of a silicon thin film solar cell according to claim 1, wherein
    the high frequency power has a frequency of 27 MHz or higher.

7. The manufacturing method of a silicon thin film solar cell according to claim 1, wherein
    the silicon thin film solar cell has a single device structure having p, i and n layers all formed with crystalline silicon.

8. The manufacturing method of a silicon thin film solar cell according to claim 1, wherein
    the silicon thin film solar cell has a tandem device structure formed by stacking a solar cell device, at least an i layer thereof is formed with crystalline silicon, and a solar cell device, at least an i layer thereof is formed with amorphous silicon.

9. The manufacturing method of a silicon thin film solar cell according to claim 1, wherein
    the silicon thin film solar cell has a tandem device structure formed by stacking a solar cell device having p, i and n layers all formed with crystalline silicon and a solar cell device having p, i and n layers all formed with amorphous silicon.

FIG.1

19
11
12

18
17
16

14
13
15
20

FIG.2

ONE CYCLE OF
PULSE MODULATION

HIGH FREQUENCY
OUTPUT ON TIME

HIGH FREQUENCY
OUTPUT OFF TIME

HIGH
FREQUENCY
OUTPUT

TIME

FIG.3

FREQUENCY

TIME

FIG.4

FREQUENCY

TIME

FIG.5

FREQUENCY

TIME

FIG.6

FREQUENCY

TIME

FIG.7

FREQUENCY

TIME

FIG.8

FREQUENCY

81

82

TIME

FIG.9

91
92
93
94
95
96

FIG.10

# EP 1 505 174 A1

**European Patent Office**

## EUROPEAN SEARCH REPORT

Application Number

EP 04 01 6125

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 1999, no. 02, 26 February 1999 (1999-02-26) -& JP 10 313125 A (SHARP CORP), 24 November 1998 (1998-11-24) * abstract; tables 1-4 * | 1-9 | C23C16/515 C23C16/24 |
| X | PATENT ABSTRACTS OF JAPAN vol. 017, no. 554 (C-1118), 6 October 1993 (1993-10-06) -& JP 05 156451 A (NISSIN ELECTRIC CO LTD), 22 June 1993 (1993-06-22) * abstract * | 1-9 | |
| X,D | MEIER J ET AL: "INTRINSIC MICROCRYSTALLINE SILICON (MUC-SI:H) - A PROMISING NEW THIN FILM SOLAR CELL MATERIAL" WORLD CONFERENCE ON PHOTOVOLTAIC ENERGY. WAIKOLOA, DEC. 5 - 9, 1994, NEW YORK, IEEE, US, vol. VOL. 1 CONF. 1, 5 December 1994 (1994-12-05), pages 409-412, XP000604456 * the whole document * | 1-9 | **TECHNICAL FIELDS SEARCHED (Int.Cl.7)** C23C |

The present search report has been drawn up for all claims

| Place of search | Date of completion of the search | Examiner |
|---|---|---|
| Munich | 29 November 2004 | Brisson, O |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 04 01 6125

This annex lists the patent family members relating to the patent documents cited in  the above-mentioned European search report.
The members are as contained in the European Patent Office EDP file on
The European Patent Office is in no way liable for these particulars which are merely  given for the purpose of information.

29-11-2004

| Patent document cited in search report | | Publication date | Patent family member(s) | | Publication date |
|---|---|---|---|---|---|
| JP 10313125 | A | 24-11-1998 | NONE | | |
| JP 05156451 | A | 22-06-1993 | JP | 2032106 C | 19-03-1996 |
| | | | JP | 7047823 B | 24-05-1995 |

EPO FORM P0459

For more details about this annex : see Official Journal of the European Patent Office, No. 12/82